# EUROPÄISCHE PATENTANMELDUNG

(11) **EP 1 191 574 A2**
(43) Veröffentlichungstag der Anmeldung: **27.03.2002**
(21) Anmeldenummer: 01120104.3
(22) Anmeldetag: 21.08.2001
(51) Int. Cl.: H01L 21/00

(54) **Chip-Zuführeinrichtung und Verfahren zum Zuführen von Halbleiterchips**

(30) Priorität: 21.09.2000 DE 10046899
(71) Anmelder: SIEMENS AKTIENGESELLSCHAFT, 80333 München (DE)
(72) Erfinder: Waeckerle, Uwe, 76646 Bruchsal (DE)

(57) **Zusammenfassung**

Chip-Zuführeinrichtung und Verfahren zum Zuführen von Halbleiterchips aus einem eine Mehrzahl von Halbleiterchips (108) aufweisenden im wesentlichen ebenen Wafer (100), bei welchem der Wafer mit der aktiven Seite (120) nach unten angeordnet wird, der Wafer (100) relativ zur Entnahmeposition (E) positioniert wird, so daß ein zu entnehmender Halbleiterchip (108) über der Entnahmeposition (E) angeordnet wird, der zu entnehmende Halbleiterchip (108) nach unten von dem Wafer (100) entnommen wird, und der entnommene Halbleiterchip (108) von der Entnahmeposition (E) in eine Übergabeposition (Ü) transportier wird.

## Beschreibung

Die Erfindung betrifft eine Chip-Zuführeinrichtung und ein Verfahren zum Zuführen von Halbleiterchips aus einem eine Mehrzahl von Halbleiterchips aufweisenden und im wesentlichen eben ausgebildeten Wafer.

Halbleiterchips werden herkömmlicherweise in einer großen Anzahl auf einen Wafer bereitgestellt. Um jeweils einen der Halbleiterchips weiter verarbeiten zu können wird der Wafer mit der aktiven Seite nach oben, d.h. mit der Seite an welcher die Halbleiterchips über Anschlußflächen oder Anschlußkörper zugänglich sind, angeordnet und auf eine Folie geklebt. Danach wird der derart hergerichtete Silizium-Wafer zersägt, so daß die einzelnen Halbleiterchips separat entnehmbar sind. Eine Art von Halbleiterchips wird nach dem Entnehmen mit der aktiven Seite nach oben auf ein Substrat gesetzt und anschließend werden die Anschlußflächen oder Anschlußkörper von oben mit dünnen Leitern mittels sogenannter Wirebond-vorrichtungen mit den Anschlußstellen des Substrats verbunden.

In jüngerer Zeit wurden Halbleiterchips entwickelt, welche auf ihrer aktiven Seite Anschlußkugeln (bumps) oder andere Anschlußkörper aufweisen. Diese werden bei der Weiterverarbeitung mit der aktiven Seite nach unten auf oft matrixartig angeordnete Anschlussstellen eines Substrates aufgesetzt. Da die Halbleiterchips herstellungstechnisch weiterhin mit der aktiven Seite nach oben im Wafer angeordnet sind müssen sie zum Aufsetzen auf das Substrat geschwenkt werden, so daß sie mit der aktiven Seite nach unten weisen. Für diese Anwendung werden in der Regel sogenannte "Flipper" oder Schwenkvorrichtungen in herkömmliche Diebond-Vorrichtungen integriert.

Bei der Verarbeitung einer Mehrzahl sogenannter "Flip-Chips" eines Wafers wird jeder Halbleiterchip zunächst von einer Pick-Up-Einrichtung von dem Wafer genommen, anschließend um 180° um eine im wesentlichen horizontale Achse geschwenkt und dann an das eigentliche Handhabungsgerät übergeben, welches das Anordnen auf dem Substrat vornimmt.

Derartige Systeme sind jedoch sehr langsam. Außerdem stellt das Schwenken der Halbleiterchips einen komplizierten Zwischenschritt mit erhöhter Fehlerrate dar.

Es ist die Aufgabe der Erfindung, eine Chip-Zuführeinrichtung sowie ein Verfahren zum Zuführen von Halbleiterchips anzugeben, bei welchem die Nachteile des Standes der Technik vermieden sind.

Diese Aufgabe wird gelöst durch die erfindungsgemäße Vorrichtung nach dem unabhängigen Anspruch 1 sowie das erfindungsgemäße Verfahren nach dem unabhängigen Anspruch 10. Bevorzugte Ausgestaltungen der Erfindung sind in den abhängigen Ansprüchen beansprucht.

Von einer erfindungsgemäßen Chip-Zuführeinrichtung kann mindestens ein eine Mehrzahl von Halbleiterchips aufweisender und im wesentlichen eben ausgebildeter Wafer aufgenommen werden. Die Chip-Zuführeinrichtung weist eine Haltevorrichtung zum Halten des Wafers im Bereich einer Entnahmeposition auf, wobei der Wafer mit den zu entnehmenden Halbleiterchips nach unten gerichtet an der Haltevorrichtung angeordnet ist, d.h. die aktive Seite der Halbleiterchips, an welchen später eine Kontaktierung der Halbleiterchips erfolgen kann, ist nach unten gerichtet angeordnet. Ferner weist die erfindungsgemäße Chip-Zuführeinrichtung eine Entnahmevorrichtung zum Entnehmen von Halbleiterchips von dem Wafer an der Entnahmeposition auf. Mittels einer Transportvorrichtung können die Halbleiterchips aus der Entnahmeposition in eine Übergabeposition transportiert werden. Durch die Anordnung des Wafers derart, daß die aktive Seite der Halbleiterchips nach unten gerichtet ist, ist es für die Weiterverarbeitung der entnommenen Halbleiterchips nicht erforderlich, diese zu wenden. Dadurch wird erfindungsgemäß der Schritt des Wendens der Halbleiterchips eingespart. Dies erspart sowohl Verarbeitungszeit als auch das Vorsehen einer technisch aufwendigen Wendestation für die Halbleiterchips. Außerdem weist die erfindungsgemäße Chip-Zuführeinrichtung eine geringere Fehlerrate auf.

Erfindungsgemäß sind die entnommenen Halbleiterchips mittels der Chip-Zuführeinrichtung im wesentlichen parallel zu der Waferebene bewegbar. Dies ermöglicht ein schnelleres Weiterverarbeiten der entnommenen Halbleiterchips.

Ferner ist der Wafer mittels der Chip-Zuführeinrichtung relativ zu der Entnahmeposition bewegbar. Dadurch kann durch Positionieren des Wafers mit dem zu entnehmenden Halbleiterchip direkt in der Nähe der Entnahmeposition das Entnehmen des jeweiligen Halbleiterchips vorbereitet werden.

Die Entnahmevorrichtung der Chip-Zuführeinrichtung weist insbesondere eine Ausstoßnadel auf, welche an der Entnahmeposition und über dem Wafer angeordnet sowie der Transportvorrichtung zugewandt ist. Mittels der Ausstoßnadel kann der zu entnehmende Halbleiterchip von dem Wafer abgehoben werden, so daß er mittels einer Aufnahmevorrichtung, welche an der Transportvorrichtung vorgesehen ist, aufgenommen und aus der Entnahmeposition in die Übergabeposition bewegbar ist. Durch Zusammenwirken der Ausstoßnadel mit der Aufnahmevorrichtung ist ein sicheres Übergeben des zu entnehmenden Halbleiterchips von dem Wafer an die Transportvorrichtung möglich.

Die Transportvorrichtung ist bevorzugt kreuzartig ausgebildet und um eine zu den Schenkeln der kreuzartigen Transportvorrichtung im wesentlichen senkrechte und durch den Symmetriepunkt der kreuzartigen Transportvorrichtung verlaufende Achse drehbar. Dadurch können an jedem der Schenkel oder Arme der Transportvorrichtung eine oder mehrere Aufnahmevorrichtungen angeordnet sein, mittels welchen entnommene Halbleiterchips zwischen der Entnahmeposition und der Übergabeposition bewegbar sind.

Die erfindungsgemäße Chip-Zuführeinrichtung kann samt dem Wafer, der Entnahmevorrichtung, der Transportvorrichtung und der Aufnahmevorrichtungen horizontal oder vertikal oder auch geneigt in einem beliebigen Winkel angeordnet sein. Ein aus dem Wafer entnommener Halbleiterchip ist dabei mit Ausnahme kleiner Bewegungen während des Entnehmen des Halbleiterchips von dem Wafer im wesentlichen parallel zu der Waferebene bewegbar.

Von der Übergabeposition aus sind die entnommenen Halbleiterchips mittels einer Handhabungseinrichtung, wie beispielsweise einer Pick-and-Place-Vorrichtung, für das Anordnen der Halbleiterchips in einem Gehäuse oder an einer Leiterplatte übergebbar.

Nach der Erfindung sind Halbleiterchips insbesondere Flip-Chips oder andere Arten von Halbleiterchips, welche mit der aktiven Seite nach unten auf ein Substrat oder auf eine Leiterplatte aufgebracht werden.

Nach dem erfindungsgemäßen Verfahren zum Zuführen von Halbleiterchips aus einem mit einer Mehrzahl von Halbleiterchips versehenen und im wesentlichen eben ausgebildeten Wafer wird zunächst der Wafer mit den Halbleiterchips, d.h. mit der aktiven Seite nach unten angeordnet. Danach wird der Wafer für jeden zu entnehmenden Halbleiterchip über einer Entnahmeposition positioniert, so daß der zu entnehmende Halbleiterchip über der Entnahmeposition angeordnet wird. Dann wird der zu entnehmende Halbleiterchip nach unten von dem Wafer entnommen und der entnommene Halbleiterchip aus der Entnahmeposition in eine Übernahmeposition transportiert.

Hierbei ist ein Wenden des entnommenen Halbleiterchips nicht erforderlich und der entnommene Halbleiterchip kann direkt, ohne gewendet zu werden, beispielsweise mittels einer Handhabungseinrichtung, von der Übergabeposition aus in einem Gehäuse für Halbleiterchips oder an einer Leiterplatte angeordnet werden. Der Halbleiterchip wird dabei im wesentlichen parallel zu der Wafer-Ebene bewegt. Insbesondere ist der Halbleiterchip für das erfindungsgemäße Verfahren ein Flip-Chip oder ein anderer Halbleiterchip, welcher mit der aktiven Seite nach unten an einem Gehäuse oder an einer Leiterplatte angeordnet werden soll.

Die Erfindung wird unter Bezugnahme auf die Zeichnung näher erläutert. In der Zeichnung zeigen:
Figur 1 eine schematische Seitenansicht einer bevorzugten Ausführungsform der erfindungsgemäßen Chip-Zuführeinrichtung, und
Figur 2 eine schematische Draufsicht auf die bevorzugte Ausführungsform der erfindungsgemäßen Chip-Zuführeinrichtung.

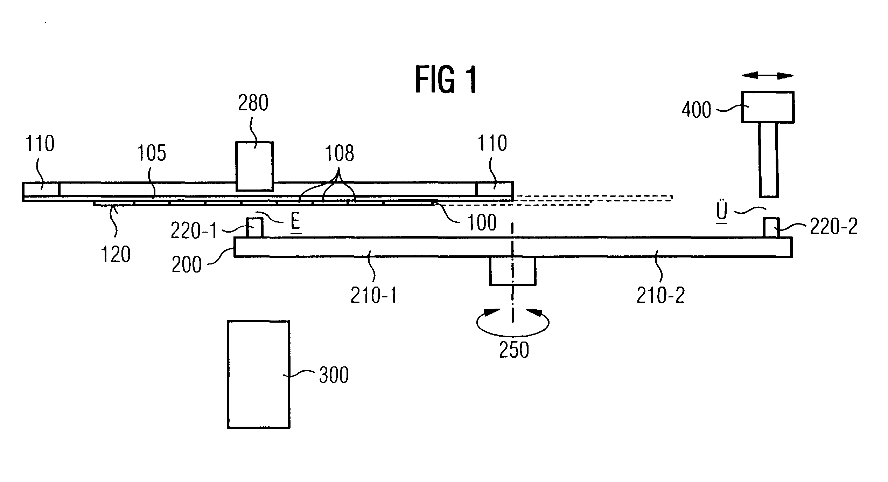

Wie aus Figur 1 ersichtlich weist eine bevorzugte Ausführungsform der erfindungsgemäßen Chip-Zuführeinrichtung eine Haltevorrichtung 110 auf, an welcher ein Wafer 100 an einer Folie 105 beispielsweise durch Verkleben mit derselben befestigt und mit der aktiven Seite 120 nach unten gerichtet angeordnet werden kann. Mittels der Haltevorrichtung 110 ist die Folie 105 mit dem Wafer 100 relativ zu einer Entnahmeposition E im wesentlichen innerhalb der Waferebene bewegbar. Der Wafer 100 weist eine Mehrzahl von Halbleiterchips 108 auf, welche von die aktive Seite 120 des Wafers bilden und von dieser aktiven Seite 120 aus zugänglich sind. Der Wafer 100 kann beispielsweise an seiner der aktive Seite 120 abgewandten Rückseite mit der Folie 105 versehen sein. Um die Halbleiterchips 108 von dem Wafer 100 entnehmen zu können kann dieser in einzelne Segmente zersägt sein, welche den Halbleiterchips 108 entsprechen. Die Folie 105 wird insbesondere vor dem Sägen an dem Wafer 100 angebracht. Die durch Sägen voneinander getrennten Segmente werden mittels einer zwischen dem Wafer 100 und der Folie 105 ausgebildeten Klebeschicht an der Folie 105 gehalten. Ein zu entnehmender Halbleiterchip 108 wird mittels der Haltevorrichtung 110 nahe der Entnahmeposition E angeordnet. Mittels einer Ausstoßnadel 280 kann der zu entnehmende Halbleiterchip 108 von der Rückseite des Wafers 100 aus unter Dehnen der Folie 105 nach unten von dem Wafer 100 abgestoßen und von einer Aufnahmevorrichtung 220-1 aufgenommen werden. Die Aufnahmevorrichtung 220-1 ist dabei ebenfalls in der Nähe der Entnahmeposition E positioniert und auf einer Transportvorrichtung 200 angeordnet. Neben einer oder mehreren Aufnahmevorrichtungen 220-1 und 220-2 weist die Transportvorrichtung 200, welche kreuzartig ausgebildet sein kann, eine Mehrzahl von Schenkeln 210-1, 210-2 auf. Die Transportvorrichtung 200 ist um eine Achse 250 drehbar, welche im wesentlichen senkrecht zu den Schenkeln 210-1, 210-2 und durch den Symmetrie-Punkt der Transportvorrichtung 200 verläuft. Unterhalb der Transportvorrichtung 200 kann in der Nähe der Entnahmeposition E eine Kamera 300 angeordnet sein, mittels welcher das Entnehmen von Halbleiterchips mittels der Ausstoßnadel 280 und der Aufnahmerichtung 220-1 von dem Wafer 100 überwacht werden kann.

Nach der bevorzugten Ausführungsform der Erfindung wird der entnommene Halbleiterchip 108 mit der aktiven Seite nach unten von der Aufnahmevorrichtung 220-1 der Transportvorrichtung 200 aufgenommen. Die passive, von der aktiven Seite abgewandte Seite des entnommenen Halbleiterchips 108 weist dabei nach oben. Mittels der Transportvorrichtung 200 wird der entnommene Halbleiterchip 108 mit der passiven Seite nach oben aus der Entnahmeposition E in eine Übergabeposition Ü transportiert. An der Übergabeposition Ü kann der entnommene Halbleiterchip 108 von einer Handhabungseinrichtung 400, wie beispielsweise einer Pick-and-Place-Vorrichtung, wie sie bei Diebond-Vorrichtungen oder SMD-Bestückvorrichtungen üblich ist, entnommen und der Weiterverarbeitung zugeführt werden.

Da der entnommene Halbleiterchip mit der passiven Seite nach oben zu der Handhabungseinrichtung 400 transportiert wird, ist ein zusätzliches Schwenken des Halbleiterchips 108 nicht erforderlich. Der Halbleiterchip 108 kann direkt mittels der Handhabungseinrichtung 400 weiter verarbeitet werden. Beispielsweise wird der Halbleiterchip von der Handhabungseinrichtung 400 über ein Gehäuse transportiert, in welches er mit der aktiven Seite nach unten eingesetzt werden soll, auf welcher sich beispielsweise Anschluß-Bumps befinden. Es ist auch möglich, den entnommenen Halbleiterchip mit der aktiven Seite nach unten direkt auf eine Leiterplatte aufzusetzen.

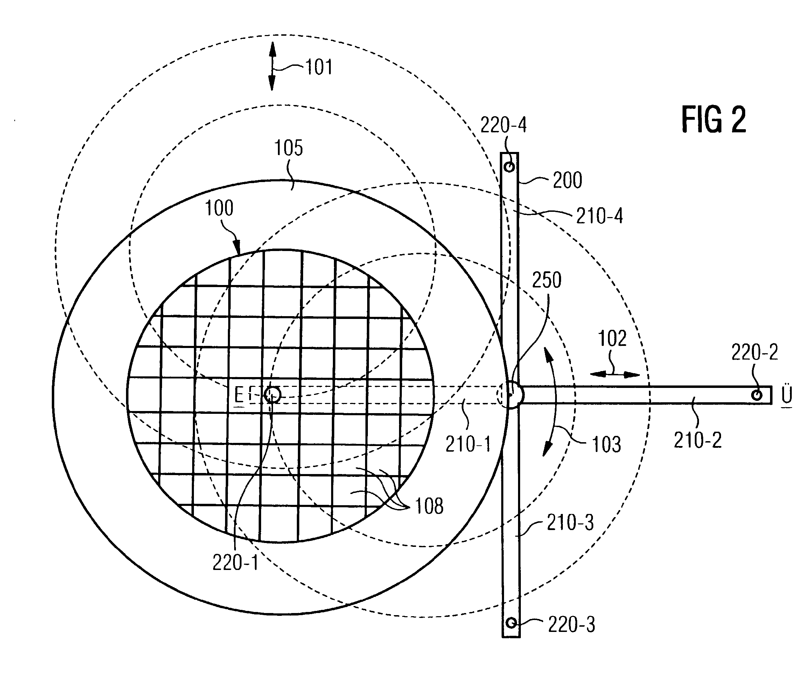

Aus Figur 2 sind die zur Positionierung des Wafers 100 zum Entnehmen eines Halbleiterchips 108 über der Entnahmeposition E durchführbaren Relativbewegungen des Wafers 100 gegenüber der Aufnahmevorrichtung 220-1 der Transportvorrichtung 200 durch die Pfeile 101 und 102 dargestellt ersichtlich. Außerdem sind die möglichen Drehbewegungen der Transportvorrichtung 200 um die Achse 250 zum Transportieren des entnommenen Halbleiterchips von der Entnahmeposition E in die Übergabeposition Ü durch den Pfeil 103 ersichtlich dargestellt. Ferner kann der Figur 2 entnommen werden, daß die Transportvorrichtung 200 nach der bevorzugten Ausführungsform der Erfindung kreuzartig ausgebildet ist und vier Schenkel 210-1, 210-2, 210-3, und 210-4 aufweist, welche jeweils an deren Endabschnitt mit einer Aufnahmevorrichtung 220-1, 220-2, 220-3 und 220-4 versehen sind. Dadurch ist es möglich, während einer Umdrehung der Transportvorrichtung 200 vier Halbleiterchips 108, welche mittels Ausstoßnadel 280 von dem Wafer 100 entnommen worden und auf einer der Aufnahmevorrichtungen 220-1, 220-2, 220-3 und 220-4 angeordnet wurden, von der Entnahmeposition E zu der Übergabeposition Ü zu transportieren. Von der Übergabeposition Ü aus können die entnommenen Halbleiterchips 108 mittels einer Handhabungseinrichtung der weiteren Verarbeitung mittels bekannter Vorrichtungen der Flip-Chip-Technologie oder auch der Diebond-Technologie oder der SMD-Technologie weiter verarbeitet werden.

## Patentansprüche

1. Chip-Zuführeinrichtung, von welcher mindestens ein eine Mehrzahl von Halbleiterchips (108) aufweisender im wesentlichen ebener Wafer (100) aufnehmbar ist mit
• einer Haltevorrichtung (110) zum Halten des Wafers (100) im Bereich einer Entnahmeposition (E), wobei der Wafer (100) mit seiner aktiven Seite (120) nach unten gerichtet an der Haltevorrichtung (110) angeordnet ist,
• einer Entnahmevorrichtung (280) zum Entnehmen der Halbleiterchips (108) von dem Wafer (100) an der Entnahmeposition (E), und
• einer Transportvorrichtung (200) zum Transportieren der Halbleiterchips (108) aus der Entnahmeposition (E) in eine Übergabeposition (Ü).

2. Chip-Zuführeinrichtung nach Anspruch 1, wobei die Halbleiterchips (108) in zu der Waferebene parallelen Ebenen bewegbar sind.

3. Chip-Zuführeinrichtung nach Anspruch 1 oder 2, wobei der Wafer (100) für das Entnehmen der Halbleiterchips (108) mittels der Haltevorrichtung (110) relativ zu der Entnahmeposition (E) bewegbar ist.

4. Chip-Zuführeinrichtung nach einem der Ansprüche 1 bis 3, wobei die Entnahmevorrichtung (280) eine Ausstoßnadel aufweist, welche an der Entnahmeposition (E) über dem Wafer (100) angeordnet und der Transportvorrichtung (200) zugewandt ist, und die Transportvorrichtung (200) unter dem Wafer (100) angeordnet ist und mindestens eine Aufnahmevorrichtung (220-1, 220-2, 220-3, 220-4) aufweist, welche mitsamt der Transportvorrichtung (200) relativ zu der Entnahmeposition (E) und relativ zu der Übergabeposition (Ü) bewegbar ist, wobei von der Aufnahmevorrichtung (220-1, 220-2, 220-3, 220-4) in Zusammenwirken mit der Ausstoßnadel das Entnehmen von Halbleiterchips (108) von dem Wafer (100) durchführbar ist.

5. Chip-Zuführeinrichtung nach Anspruch 4, wobei die Transportvorrichtung (200) kreuzartig mit mehreren Schenkeln (210-1, 210-2, 210-3, 210-4) ausgebildet und um eine zu den Schenkeln (210-1, 210-2, 210-3, 210-4) im wesentlichen senkrechte, durch den Symmetriepunkt der kreuzartigen Transportvorrichtung (200) verlaufende Achse (250) drehbar ist.

6. Chip-Zuführeinrichtung nach Anspruch 5, wobei jeweils am Endabschnitt der Schenkel (210-1, 210-2, 210-3, 210-4) der kreuzartigen Transportvorrichtung (200) eine der Aufnahmevorrichtungen (220-1, 220-2, 220-3, 220-4) angeordnet ist.

7. Chip-Zuführeinrichtung nach einem der Ansprüche 1 bis 6, wobei die entnommenen Halbleiterchips (108) an der Übergabeposition (Ü) mittels einer Handhabungseinrichtung (400) zum Anordnen der Halbleiterchips (108) in einem Gehäuse oder an einer Leiterplatte übergebbar sind.

8. Chip-Zuführeinrichtung nach Anspruch 7, wobei die Halbleiterchips (108) beim Übergeben in einer zur Waferebene parallelen Ebene bewegbar sind.

9. Chip-Zuführeinrichtung nach einem der Ansprüche 1 bis 8, wobei der Halbleiterchip (108) ein Flip-Chip oder ein Bare-Die-Chip ist.

10. Verfahren zum Zuführen von Halbleiterchips aus einem eine Mehrzahl von Halbleiterchips (108) aufweisenden im wesentlichen ebenen Wafer (100) mit folgenden Schritten
- Anordnen des Wafers (100) mit seiner aktiven Seite (120) nach unten,
- Positionieren des Wafers (100) relativ zu einer Entnahmeposition (E), so daß ein zu entnehmender Halbleiterchip (108) an der Entnahmeposition (E) angeordnet wird,
- Entnehmen des zu entnehmenden Halbleiterchips (108) nach unten von dem Wafer (100), und
- Transportieren des entnommenen Halbleiterchips (108) von der Entnahmeposition (E) zu einer Übergabeposition (Ü).

11. Verfahren nach Anspruch 10, wobei der Halbleiterchip (108) an der Übergabeposition (Ü) von einer Handhabungseinrichtung (400) aufgenommen und von dieser in einem Gehäuse oder einer Leiterplatte angeordnet wird.

12. Verfahren nach Anspruch 11, wobei der Halbleiterchip (108) im wesentlichen parallel zu der Waferebene bewegt wird.

13. Verfahren nach einem der Ansprüche 10 bis 12, wobei der Halbleiterchip (108) ein Flip-Chip oder ein Bare-Die-Chip ist.
